(19) Europäisches Patentamt
European Patent Office
Office européen des brevets

(11) **EP 2 731 220 B1**

(12) **FASCICULE DE BREVET EUROPEEN**

(45) Date de publication et mention
de la délivrance du brevet:
**10.02.2016 Bulletin 2016/06**

(51) Int Cl.:
*H02J 3/00* (2006.01)          *H02J 13/00* (2006.01)
*G01R 19/25* (2006.01)

(21) Numéro de dépôt: **13187243.4**

(22) Date de dépôt: **03.10.2013**

(54) **Dispositif et procédé de détermination de la tension et de la puissance de chaque phase dans un réseau moyenne tension**

Vorrichtung und Verfahren zur Bestimmung der Spannung und der Leistung jedes Phasenleiters eines Mittelspannungsnetzes

Device and method for determining voltage and power of each phase of a medium voltage network

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.11.2012 FR 1260722**

(43) Date de publication de la demande:
**14.05.2014 Bulletin 2014/20**

(73) Titulaire: **Schneider Electric Industries SAS**
**92500 Rueil-Malmaison (FR)**

(72) Inventeurs:
• **Message Thebaudeau, Laetitia**
**38050 GRENOBLE Cedex 09 (FR)**

• **Mollier, Christophe**
**38050 GRENOBLE Cedex 09 (FR)**
• **Sinistro, Stéphane**
**38050 GRENOBLE Cedex 09 (FR)**

(74) Mandataire: **Péru, Laurence**
**Schneider Electric Industries SAS**
**Service Propriété Industrielle**
**WTC-38EE1**
**5 pl. Robert Schuman**
**38050 Grenoble Cédex 09 (FR)**

(56) Documents cités:
**EP-A1- 1 324 455     WO-A1-00/48284**
**WO-A2-03/079512     WO-A2-2010/083164**

## Description

## DOMAINE TECHNIQUE

L'invention concerne la détermination des phaseurs de tension et de courant sur un réseau moyenne tension de manière précise sans nécessiter de capteurs sophistiqués, ainsi que la détermination et la surveillance de la puissance développée par chacun des conducteurs par l'intermédiaire de moyens usuellement disponibles sur les réseaux moyenne tension.

## ETAT DE LA TECHNIQUE

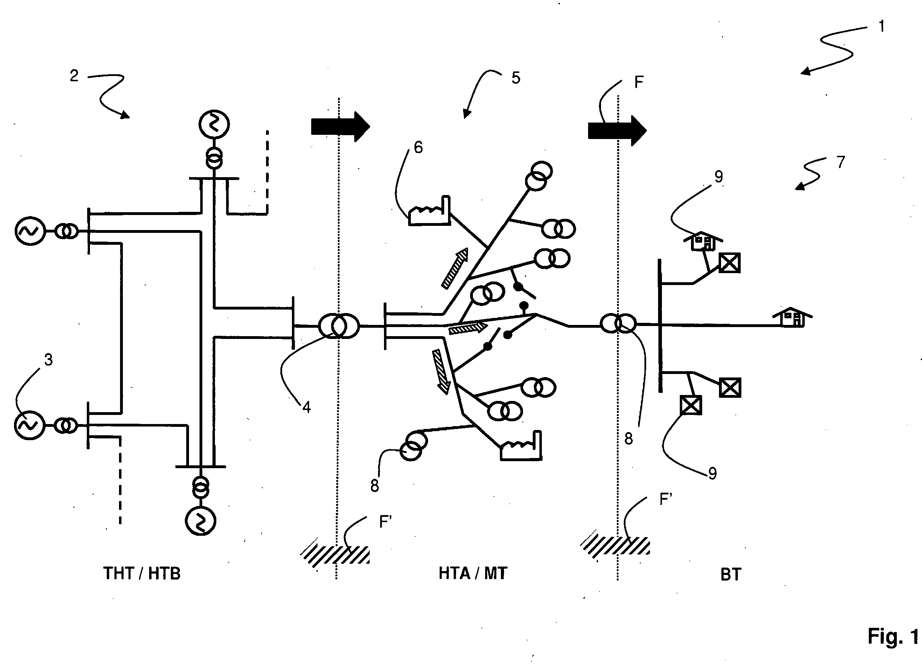

Tel qu'illustré en figure 1, les réseaux électriques 1 sont généralement architecturés en plusieurs niveaux, avec un premier réseau 2 de transport et de répartition très haute et haute tensions THT/HTB (de 35 à plus de 200 kV), utilisé pour transporter ou répartir l'énergie électrique depuis les centrales de production 3 sur de grandes distances. Après transformation 4, un réseau de distribution 5 moyenne tension HTA ou MT, usuellement entre 1 et 35 kV, et plus précisément 15 ou 20 kV en France, lui succède pour des transports à plus petite échelle, vers des clients de type industriels 6 ou vers des réseaux basse tension BT 7 (en particulier 0,4 kV en France) via d'autres postes de transformation 8 ; un réseau BT 7 alimente les clients 9 de faible demande énergétique. L'alimentation classique est ainsi un flux unidirectionnel F d'électricité.

Le niveau d'équipement de ces réseaux 1 en termes de contrôle et monitorage n'est pas uniforme : les réseaux 2 HT sont relativement bien équipés du fait de leur structure réduite et maillée, ainsi que de leur importance quant à l'équilibre entre production et consommation du réseau ; les réseaux BT 7 sont eux aussi relativement bien équipés entre les mesures au secondaire du transformateur des postes de distribution 8 et celles en provenance des compteurs de facturation 9. Par contre, les réseaux 5 MT sont principalement dotés d'équipements visant à assurer leur protection ou leur reconfiguration, sans fournir beaucoup de mesures.

De fait, sur le réseau 5, les capteurs de courant ou de tension sont le plus souvent intégrés à des matériels remplissant une autre fonction, comme la coupure ou la télécommande, qui peut conditionner la technologie du capteur, généralement défini dans un contexte normatif. Ainsi, les sous-stations de distribution 8 sont fréquemment équipées de matériel de télé-conduite, avec des capteurs de courant au niveau de la MT d'installation et de précision acceptables. Cependant, la captation de la tension MT reste problématique, pour des raisons de coût de capteurs et d'installation intrusive qui rend difficile toute mise à jour des réseaux 5 existants : le fait de vouloir contrôler et commander le réseau MT 5 implique des niveaux sévères d'isolement entre les capteurs et l'électronique bas signal chargée de mettre en forme et d'exploiter ces mesures. Les mesures disponibles ne permettent ainsi généralement pas de procéder à du monitorage, par manque de précision ou non respect des exigences normatives relatives aux fonctions initiales.

Or il semble nécessaire de pouvoir accéder à une surveillance suffisante et précise des réseaux 5 moyenne tension dans le nouveau paradigme des réseaux intelligents, appelés «Smart Grids » : l'insertion de moyens de production décentralisée, tant en MT et qu'en BT, avec les panneaux photovoltaïques, fermes éoliennes et microcentrales, peut conduire à des flux de courant et de puissance inversés non traditionnels F'. Il convient alors d'observer et contrôler les flux de courant F, F' (pour garantir le respect des courants transitant sur les différents conducteurs en regard de leur section et de leur courant nominal admissible), les tensions en plusieurs points (pour garantir le respect du plan de tension contractuel), les puissances actives, apparentes et réactives (pour permettre un contrôle de flux de puissance (ou *« power flow monitoring »* selon le terme anglosaxon)).

Les mesures classiques de puissance triphasée au primaire d'un transformateur 8 nécessitent de mesurer les trois courants primaires et les trois tensions primaires de phase, les puissances étant déduites par multiplication terme à terme. Pour ce faire, il est donc nécessaire de disposer de capteurs adéquats pour les courants et les tensions, ainsi que des centrales de mesure : les solutions existantes utilisent des éléments onéreux, et la mise à jour des réseaux 5 peut s'avérer impossible pour des raisons d'accessibilité.

De fait, dans un poste de transformation 8 MT/BT, si la mesure des trois courants primaires est facilement réalisable à l'aide de tores, éventuellement ouvrants, installés sur les câbles, la mesure des trois tensions primaires est plus problématique, car les points de connexion ne sont pas toujours accessibles ou disponibles. Les mesures parfois réalisables au niveau des capacités de traversée (ou « *bushing* ») peuvent quant à elles présenter des déséquilibres entre phases, dus notamment au vieillissement de ces capacités ; qui plus est, ce genre de mesure n'a qu'un faible niveau de précision (par exemple, des écarts de valeurs pouvant aller de -25 à +25 % sont admis en France). Dans tous les cas, ces dispositifs sont souvent volumineux et leur installation, nécessite l'interruption de l'alimentation du poste concerné.

WO 2010/083164 A, WO 03/079512 A, WO 00/48284 A et EP 1 324 455 A décrivent des procédés et dispositifs de détermination de l'intesité et de la tension.

Pour obtenir une précision acceptable sur des mesures de puissance, et donc les mesures de tension coté primaire, la présente invention concerne la restitution de mesures de tensions et puissances triphasées dans les postes MT/BT, avec la particularité de recourir aux informations de tensions mesurées coté BT.

## EXPOSE DE L'INVENTION

La présente invention résout le problème par un procédé selon la revendication 1 et par un dispositif selon la revendication 9.

Parmi autres avantages, l'invention vise à pallier des inconvénients de la surveillance existante des réseaux moyenne tension et à proposer un système permettant d'utiliser les dispositifs de mesure classiques pour un monitorage efficace du réseau.

L'invention, tant au niveau procédé que dispositif, est conçue pour un réseau triphasé moyenne tension dont le facteur de puissance, ou cosinus phi, est supérieur à 0,89, par exemple supérieur ou égal à 0,93 en France. Le réseau moyenne tension est couplé vers un réseau basse tension triphasé à un transformateur moyenne/basse tension dont les paramètres de transformation sont connus et peuvent être entrés pour les déterminations selon l'invention.

En particulier, sous un de ses aspects, l'invention concerne un procédé de détermination de l'intensité et de la tension du courant de chaque phase dans un tel réseau moyenne tension, qui comprend une première étape de détermination du phaseur, ou couple amplitude/angle, de courant sur chacun des conducteurs de phase du réseau moyenne tension, de l'angle du phaseur de tension sur chacun des conducteurs de phase du réseau moyenne tension et du phaseur de tension sur chacun des conducteurs de phase du réseau basse tension. Ces déterminations de phaseurs sont précédées par la mesure de signaux représentatifs du courant et de la tension sur au moins une phase du réseau moyenne tension, ainsi que de la tension sur au moins une phase du réseau basse tension, lesdits signaux étant utilisés par le procédé selon l'invention qui comprend l'étape préliminaire de leur obtention ou réception. De préférence, chacun desdits signaux représentatifs, ou éventuellement certains d'entre eux, sont mesurés pour chaque conducteur de phase ; alternativement, les signaux représentatifs des autres phases non mesurées sont obtenus par rotation angulaire de 120° et 240° en mode normal de fonctionnement.

Le procédé comprend ensuite le calcul de trois phaseurs dérivés de tension pour la moyenne tension en modifiant les phaseurs de tension pour la basse tension selon les paramètres du transformateur.

Le procédé comprend enfin l'appariage d'un triplet de trois phaseurs d'intensité déterminés dans la première étape et d'un triplet de trois phaseurs de tension reconstitués, cet l’appariage étant ainsi associé avec une reconstitution d'un triplet de phaseurs de tension moyenne tension en substituant, dans les phaseurs de tension dérivés, l'angle par un des angles déterminés dans la première étape directement sur la base du signal représentatif de la tension obtenu. Cette étape d'appariage/reconstitution comprend la comparaison pour chaque composant des paires de phaseurs de son cosinus phi avec le facteur de puissance minimale du réseau, et la sélection de la paire de trois phaseurs dont le cosinus phi est supérieur audit facteur de puissance ; de préférence, le cosinus phi de chaque paire est calculé via le calcul des puissances active et apparente et de leur rapport pour chaque composant de la paire. Dans un mode de réalisation préféré, le procédé est interrompu dès qu'une paire de trois phaseurs peut être sélectionnée, et les indices de phase sont réattribués à cette paire sélectionnée, ainsi qu'aux phaseurs de tension basse tension.

Avantageusement, le procédé de détermination de l'intensité et de la tension du courant de chaque phase précédent est utilisé dans un procédé de surveillance selon l'invention, dans lequel les couples de phaseurs intensité/tension des conducteurs sont utilisés pour donner des informations quant aux différentes puissances circulant dans le réseau moyenne tension et/ou dans chaque conducteur en utilisant les formules de puissance adaptées, comme les puissances active, réactive et apparente et facteur de puissance totales et par phase, ainsi que les transits d'énergie. Alternativement ou en complément, les informations fournies par les phaseurs réindexés sont utilisés pour fournir des informations relatives au monitorage du réseau, comme les valeurs efficaces du courant et de la tension dans chaque conducteur, les taux harmoniques de distorsion respectifs, les valeurs moyenne, minimum et maximum sur des fenêtres temporelles, voire les transits d'énergie.

Sous un autre aspect, l'invention se rapporte à un dispositif de détermination de l'intensité et de la tension du courant de chaque phase dans un réseau tel que défini. Le dispositif peut également être adapté pour la surveillance de réseau.

Le dispositif selon l'invention comprend un module d'obtention des phaseurs relatifs à la tension des conducteurs du réseau moyenne tension, à la tension des conducteurs du réseau basse tension, et à l'intensité du courant circulant dans les conducteurs du réseau moyenne tension ; alternativement, pour la tension moyenne tension, seul l'angle du phaseur peut être obtenu. Le module d'obtention comprend également des moyens pour calculer trois phaseurs de tension dans le réseau moyenne tension dérivé des phaseurs de tension du réseau basse tension.

Le module d'obtention comprend ainsi des moyens pour recevoir un signal représentatif de chaque grandeur du courant pour au moins un conducteur, et de préférence pour chacun des trois conducteurs ; ces signaux sont avantageusement filtrés et échantillonnés avant la détermination des phaseurs dans des moyens adaptés. De préférence, le dispositif selon l'invention comprend des capteurs pour mesurer les grandeurs correspondantes du courant sur le réseau et les fournir au module d'obtention.

Le dispositif selon l'invention comprend en outre un module de reconstitution et d'appariage pour sélectionner une paire de trois phaseurs de courant et de tension pour les conducteurs du réseau moyenne tension. Les phaseurs de tension pour la paire sont reconstitués par des moyens du module d'appariage en substituant, dans chacun des phaseurs dérivés, l'angle par un des angles obtenus via le signal représentatif de la tension des conducteurs moyenne tension. La paire sélectionnée par le module d'appariage est telle que la qualité du courant circulant dans chaque conducteur soit conforme aux caractéristiques du réseau, c'est-à-dire que le facteur de puissance ou cosinus phi de chaque conducteur est supérieur à la valeur limite du réseau, notamment à 0,89 ou 0,93. Le module d'appairage comprend ainsi des moyens pour calculer les puissances actives et apparentes des différentes paires de trois phaseurs, des moyens pour comparer leur rapport au cosinus phi minimal du réseau, et des moyens pour sélectionner une paire remplissant lesdits critères. Avantageusement, si les moyens pour sélectionner ne fournissent aucun résultat, le dispositif selon l'invention comprend des moyens d'alarme l'indiquant.

Le dispositif selon l'invention peut comprendre en outre un module de détermination de paramètres de puissance pour les conducteurs du réseau moyenne tension sur la base des paires issues du module d'appariage. Un module de surveillance des paramètres du courant circulant dans les conducteurs du réseau peut également faire partie du dispositif selon l'invention en utilisant les données issues du module d'appariage. Le dispositif selon l'invention peut enfin comprendre une interface permettant de communiquer, via un afficheur ou une transmission vers une unité centrale, les informations issues du module de surveillance et/ou du module de détermination de puissances.

## BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.

La figure 1, déjà décrite, représente un réseau électrique.

La figure 2 montre un dispositif selon un mode de réalisation préféré de l'invention, décomposé dans les deux figures 2A et 2B pour une meilleure lisibilité.

## DESCRIPTION DETAILLEE D'UN MODE DE REALISATION PREFERE

Pour éviter toute confusion, dans la suite de la description, le terme phase sera utilisé pour identifier la phase au sens du réseau triphasé (phase A, B ou C) ; pour désigner une valeur angulaire, on parlera d'angle. Ainsi, selon la terminologie consacrée, le phaseur d'une grandeur électrique X est défini par son amplitude $A_X$ et son angle $\theta_X$, c'est-à-dire qu'un phaseur de tension sur la phase A correspond au couple ($A_{V\_A}$, $\theta_{V\_A}$), couramment représenté par la formule $A_{V\_A} \angle \theta_{V\_A}$.

Afin de procéder à un monitorage de puissance efficace, et pour éviter le recours à des capteurs de tension de coût prohibitif et permettre de mettre à jour chaque réseau MT 5 existant même si l'accessibilité est complexe, selon l'invention, les mesures sont réalisées par l'intermédiaire d'équipements présents sur le réseau 5, ou facilement adaptables, tant d'un point de vue industriel qu'économique.

Il apparaît que la mesure de la tension côté BT d'un transformateur 8 ne présente pas de difficulté majeure, les conducteurs étant facilement accessibles. Les informations ainsi obtenues peuvent être aisément mises à l'échelle via les paramètres caractéristiques du transformateur MT/BT (couplage, rapport de transformation et indice horaire), pour obtenir un phaseur dérivé de tension MT. Cependant, si les capteurs existants permettent de déterminer une amplitude de tension BT et une amplitude dérivée MT avec une très bonne précision, de l'ordre de 0,5 à 1 %, l'information relative à l'angle de tension est très peu précise.

Inversement, l'information relative à l'angle de la tension côté MT peut être obtenue avec une grande précision par des dispositifs existants, de type diviseur capacitif ou système indicateur de présence de tension VPIS (pour « *Voltage Presence Indicating System* »), présents dans les postes MT/BT ; ces dispositifs ne permettent cependant pas la mesure de l'amplitude avec suffisamment de précision.

Selon l'invention, les deux mesures sont utilisées pour reconstituer une mesure précise des phaseurs de tension MT, en prenant l'amplitude dérivée de la mesure de tension BT et l'angle mesuré sur les conducteurs MT. Il apparaît cependant que les conducteurs ne sont pas toujours repérés dans une sous-station 8, de sorte que l'installation des capteurs ne peut garantir que la même phase soit conservée pour les mesures en amont et en aval : il convient de s'assurer que les deux informations sont correctement associées, étant donné que la mesure se fait à des endroits différents et sur des conducteurs différents.

L'information relative aux caractéristiques de la tension est complétée par la mesure directement sur le réseau MT 5 des informations relatives à l'intensité du courant y circulant. Ici encore, l'appariage entre phases au regard de la tension n'est pas intrinsèque, les capteurs de tension et de courant étant classiquement éloignés l'un de l'autre.

Afin de permettre la détermination effective du phaseur reconstitué de tension et son appariage avec l'intensité, l'invention tire parti des conditions normatives du réseau 1 en ce qui concerne la qualité du courant fourni sur les réseaux 2, 5, 7. De fait, en fonctionnement nominal du réseau 1, c'est-à-dire hors défaut, les fournisseurs d'électricité s'assurent que l'angle entre les puissances apparentes S et actives P (dans le plan de représentation (P,Q)) ne présente pas un facteur de puissance inférieur à une valeur déterminée, et notamment

on a |cos φ| ≥ 0,93 en France, et plus généralement |cos φ| ≥ 0,9 dans la majeure partie des pays d'Europe. Ce cos φ qui correspond au rapport entre puissances active et apparente permet de limiter la part de la puissance réactive Q (utilisée pour transporter l'énergie selon F alors que les unités de production 3 ne délivrent qu'une puissance apparente S), et maximiser la puissance active P facturée effectivement au client. L'angle φ correspondant, au maximum 21,56° dans le cas de la France, est aussi l'angle entre le vecteur du courant de phase et le vecteur de la tension simple entre ladite phase et le neutre associée, dans le plan des phaseurs tension/courant. Ainsi, on utilise le calcul de puissances triphasées, objectif de l'invention, pour lever l'indétermination sur les appariages et reconstitutions permettant d'atteindre ce résultat.

Selon l'invention, l'appariage des phaseurs MT de courant et de tension est donc réalisé via le calcul du rapport puissance active P sur puissance apparente S, l'appariage correct devant vérifier la condition que le cos φ est supérieur à une référence normée, notamment 0,9, qui correspond à ce que le courant et la tension associée s'inscrivent dans un secteur angulaire de ± 25° si on prend en compte les erreurs de mesure et calcul possibles : ces secteurs angulaires ne se recouvrent pas.

En particulier, il est possible de décomposer le procédé de détermination des paires de phaseurs intensité/tension moyenne tension.

### Etape I

Dans un premier temps, trois couples amplitude/angle $(A \angle \theta)$ sont déterminés pour les courants MT, tensions MT et tensions BT, avec de préférence les :

- obtention de signaux représentatifs des trois courants pour chacun des conducteurs de phase R,S,T moyenne tension $I_{MT\_R}$, $I_{MT\_S}$, $I_{MT\_T}$ ; avantageusement, les signaux représentatifs sont filtrés et échantillonnés ; les phaseurs correspondant à ces courants $A_{I\_MT\_R} \angle \theta_{I\_MT\_R}$, $A_{I\_MT\_S} \angle \theta_{I\_MT\_S}$, $A_{I\_MT\_T} \angle \theta_{I\_MT\_T}$ sont déterminés ;
- obtention de signaux représentatifs des trois tensions pour chacune des phases U,V,W du réseau moyenne tension $V_{MT\_U}$, $V_{MT\_V}$, $V_{MT\_W}$ et extraction des informations relatives à leur angle $\theta_{V\_MT\_U}$, $\theta_{V\_MT\_V}$, $\theta_{V\_MT\_W}$ ; avantageusement, les signaux représentatifs obtenus $V_{MT\_U}$, $V_{MT\_V}$, $V_{MT\_W}$ sont filtrés et échantillonnés, avant de procéder à une détermination des phaseurs $A_{V\_MT\_U} \angle \theta_{V\_MT\_U}$, $A_{V\_MT\_V} \angle \theta_{V\_MT\_V}$, $A_{V\_MT\_W} \angle \theta_{V\_MT\_W}$ ;
- obtention de signaux représentatifs des trois tensions pour chacun des conducteurs de phase X,Y,Z basse tension $V_{BT\_X}$, $V_{BT\_Y}$, $V_{BT\_Z}$ ; avantageusement, les signaux représentatifs sont filtrés et échantillonnés ; les phaseurs correspondants $A_{V\_BT\_X} \angle \theta_{V\text{-}BT\_X}$, $A_{V\_BT\_Y} \angle \theta_{V\text{-}BT\_Y}$, $A_{V\_BT\_Z} \angle \theta_{V\_BT\_Z}$ sont déterminés.

### Etape II

Dans un deuxième temps, un couple dérivé amplitude/angle est calculé pour la tension de chaque phase en moyenne tension, en mettant à l'échelle et modifiant selon les paramètres caractéristiques du transformateur 8 les phaseurs de tension BT. Ces pseudo-phaseurs $A_{V\_MT\_X} \angle \theta_{V\_MT\_X}$, $A_{V\_MT\_Y} \angle \theta_{V\_MT\_Y}$, $A_{V\_MT\_Z} \angle \theta_{V\_MT\_Z}$ correspondent à des triplets de phases X,Y,Z, dont l'angle a été dérivé selon l'indice horaire et le type de couplage du transformateur, le rapport de transformation étant également pris en compte pour l'amplitude.

### Etape III

Un troisième stade concerne la détermination pour chaque conducteur de phase A,B,C moyenne tension des informations relatives au phaseur d'intensité $A_{I\_MT\_RST} \angle \theta_{I\_MT\_RST}$, à l'amplitude $A_{V\_MT\_XYZ}$ issue du pseudo-phaseur de tension $A_{V\_MT\_XYZ} \angle \theta_{V\text{-}MT\_XYZ}$, et à l'angle $\theta_{V\_MT\_UVW}$ issu du phaseur de tension $A_{V\_MT\_UVW} \angle \theta_{V\_MT\_UVW}$ : les capteurs n'étant pas installés physiquement au même endroit dans la sous-station, il n'est pas garanti que l'ordre de succession des phases soit similaire ou que la simple affectation des indices lors des mesures soit correcte. Les paires de triplets intensité/courant sont sélectionnées pour que dans chaque conducteur soit respecté l'écart angulaire entre tension et courant tel que défini par le distributeur d'électricité, à savoir qu'ils présentent un cosinus supérieur en valeur absolue à 0,93 en France. Ces conditions sur les cosinus des écarts angulaires des paires tension/courant sont vérifiées de préférence en procédant au calcul respectif des puissance active P et apparente S des différents triplets $(A_{I\_MT\_RST} \angle \theta_{I\_MT\_RST} ; A_{V\_MT\_XYZ} ; \theta_{V\_MT\_UVW})$.

La puissance active P, respectivement réactive Q, du réseau triphasé 5 correspond à la somme des puissances actives $P_i$, respectivement réactive $Q_i$, de chaque phase, avec $P_i = V_{iN} \cdot I_i \cdot \cos \varphi_{V,I}$, respectivement $Q_i = V_{iN} \cdot I_i \cdot \sin \varphi_{V,I}$, où $V_{iN}$ est la mesure de la tension simple phase/neutre, $I_i$ la mesure du courant dans la phase, et $\varphi_{V,I}$ l'écart angulaire entre tension et courant de la phase. Le cosinus phi, ou facteur de puissance, est le rapport entre puissances active P et apparente S, cos φ = P/S,

avec $S = \sqrt{P^2 + Q^2}$ .

Bien que le nombre de possibilités de reconstitutions et d'appariages, à savoir $(3!)^3 = 216$, soit important, de fait seule une paire de triplets de phaseurs satisfait le critère de qualité du courant. La troisième étape peut donc être interrompue dès qu'une paire testée a satisfait le critère mentionné.

Le nombre de calculs théoriques peut être réduit en procédant par itérations et vérifications. En particulier, dans un premier temps, il est possible de procéder aux calculs mentionnés de puissance et cosinus phi pour des paires de phaseurs (A $_{I\_MT\_RST}$ ∠ θ $_{I\_MT\_RST}$ ; A $_{V\_MT\_XYZ}$ ∠ θ $_{V\_MT\_UVW}$) dans lesquels la substitution de l'angle du couple dérivé a été réalisée par le choix, parmi les angles de tension MT mesurés, de l'angle « le plus proche », c'est-à-dire par exemple par minimisation des écarts-types.

Si aucun appariage ne remplit les conditions de cosinus phi à la fin de ce troisième stade, une alarme peut être émise pour recommander une vérification des réglages et/ou paramètres utilisés, et/ou une vérification de l'installation, par exemple le fonctionnement et la mise en place des capteurs. De la même façon, si un appairage s'avère correct, il est avantageux que la valeur signée du cosinus soit testée : en cas de valeur négative, une recommandation peut être émise pour vérifier l'installation des capteurs, notamment quant au sens de succession des phases (sens horaire ou anti-horaire), et/ou le choix de convention quant au sens prédéfini pour la circulation d'énergie.

Une fois les paires phaseur de courant/phaseur de tension reconstituées pour chacun des conducteurs moyenne tension, les indices des phaseurs sont tous réalignés sur un triplet de phases A,B,C choisi comme référence. De préférence, la référence choisie correspond au triplet R,S,T de mesures du courant en moyenne tension étant donné que les capteurs sont pour cette mesure clairement associés aux conducteurs et directement identifiables pour toute action sur ledit conducteur.

Une indication des informations relatives au courant et à la tension circulant sur chacune des phases du réseau MT 5 peut être fournie, soit de façon passive via un afficheur, soit vers une unité de contrôle et/ou commande.

### *Etape IV*

L'invention peut ainsi être complétée par un quatrième stade, dans lequel, pour chaque grandeur, sont déterminés les paramètres permettant une surveillance précise, comme son amplitude, son angle, sa valeur efficace RMS, son taux harmonique de distorsion THD, etc., c'est-à-dire toute fonction telle que définie selon la norme EN 50160. Alternativement ou en complément, les mesures des puissances et énergies peuvent être calculées à intervalles réguliers, pour être transmises à un utilisateur, que ce soit par voie d'affichage, par sortie numérique ou analogique vers un appareil de surveillance, ou par transmission (filaire ou non) vers une unité centrale de contrôle. Le procédé de surveillance peut bien entendu être accompagné d'alarmes en cas de défaut identifié dans les données calculées et fournies par rapport à des valeurs de référence.

La limite du procédé selon l'invention repose dans l'identification de secteurs angulaires distincts, c'est-à-dire que l'angle maximum admissible entre tension et intensité est de 30° avec une précision de mesure et calcul de 100 % ; comme une erreur de l'ordre de 1 à 2° est plutôt la norme avec le procédé selon l'invention, il importe que le cos phi soit supérieur à 0,883, de préférence 0,89, sur le réseau 5. Sous cette réserve, par le procédé selon l'invention, il est ainsi possible de procéder, sans dispositif onéreux et sur la base des équipements déjà présents sur la majorité des réseaux 5, à la surveillance des puissances actives/réactives, en supervisant les transits de puissance, y compris en provenance des productions décentralisées, et le transit de puissance réactive en respect des engagements contractuels, et notamment de fournir :

- les données de monitoring des tensions triphasées BT réindexées (A,B,C) (amplitude, angle, RMS, THD..) ;
- les données de monitoring des tensions triphasées MT réindexées (A,B,C) (amplitude, angle, RMS, THD..) ;
- les données de monitoring des courants triphasés MT réindexés (A,B,C) (amplitude, angle, RMS, THD..) ;
- les données de monitoring des puissances et énergies MT réindexées (A,B,C) (puissance active, puissance réactive, puissance apparente, énergie active, réactive...).

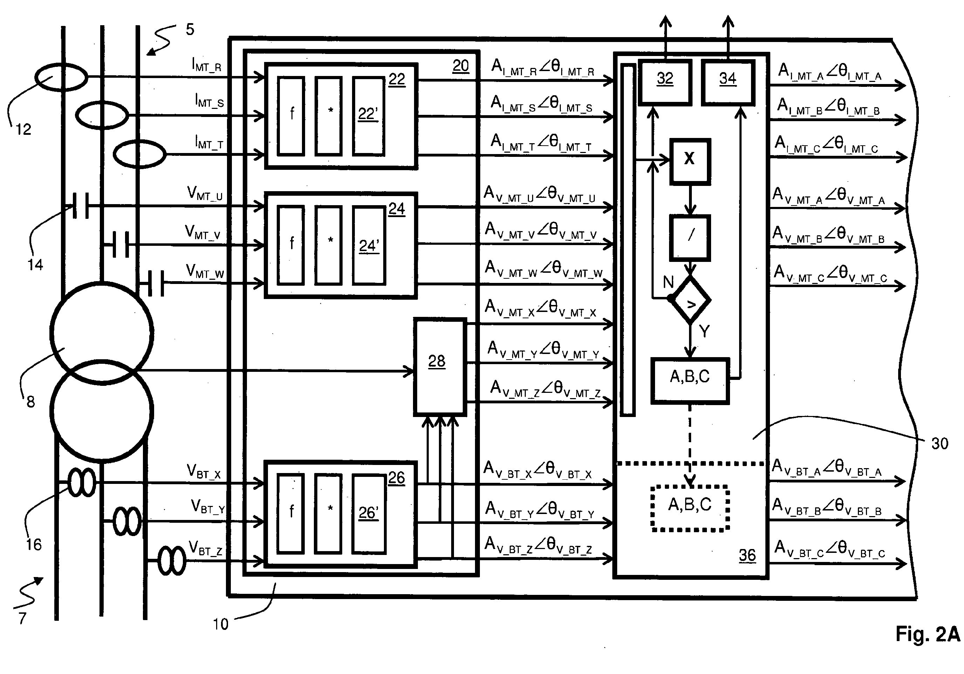

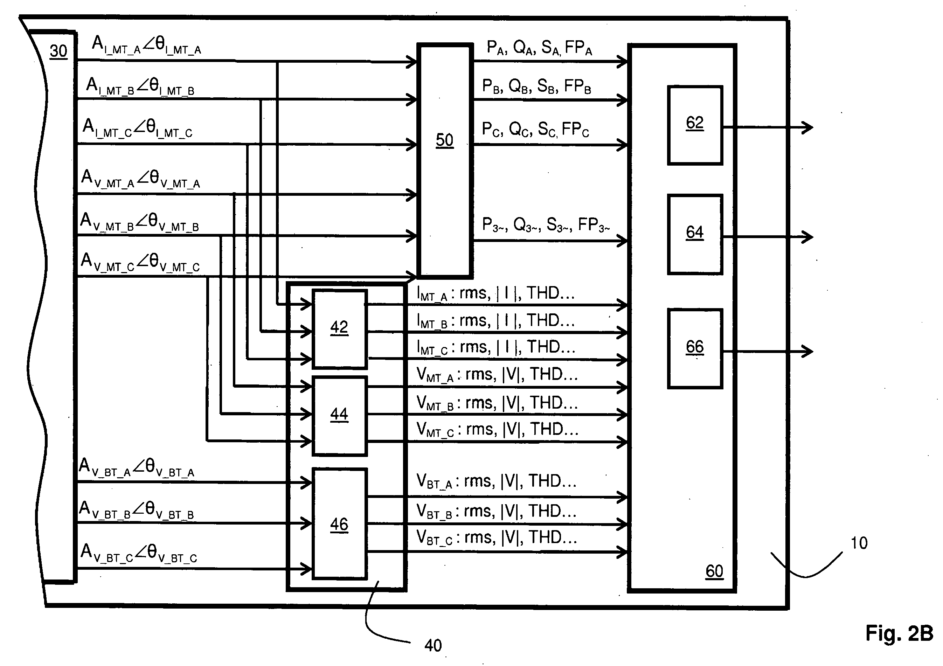

Pour permettre d'utiliser le procédé précédent et délivrer les informations relatives à la surveillance du réseau MT, un dispositif 10 selon l'invention, illustré en figure 2, peut être mis en place dans les réseaux existants 5, dont les paramètres du transformateur MT/BT 8 sont connus. Le réseau 5 comprend des moyens de mesure adaptés, notamment :

- des moyens 12 de mesure d'un signal représentatif du courant de chaque phase moyenne tension ;
- des moyens 14 de mesure d'un signal représentatif de la tension de chaque phase moyenne tension ;
- dès moyens 16 de mesure d'un signal représentatif de la tension de chaque phase basse tension.

En particulier, les dispositifs 12, 14, 16 utilisés pour la télé-conduite et leurs capteurs sont utilisés : de fait, ces capteurs sont simples d'installation et de mise en oeuvre s'ils n'existent pas déjà sur le réseau 5. Ainsi,

- des tores ouvrants 12 ou autres capteurs sont faciles à installer sur chaque conducteur pour assurer la mesure de courant MT ;
- un VPIS 14 est un équipement obligatoire dans une cellule de sous-station selon la norme CEI-61958 et permet d'assurer une mesure de la tension MT ; alternativement, un diviseur capacitif et/ou résistif peut être localisé au niveau du transformateur 8 ;
- la tension du côté BT peut être obtenue aisément par des transformateurs de mesure 16, ou autres capteurs, étant donné que les trois conducteurs BT sont accessibles en sortie du transformateur MT/BT 8.

Le dispositif 10 selon l'invention comprend un premier module 20 à au moins neuf plus une entrées, ou moyens de réception, permettant le traitement des signaux représentatifs du courant et de la tension obtenus par les capteurs 12, 14, 16 et la détermination des phaseurs correspondants. En particulier, le premier module 20 de détermination des phaseurs peut comprendre des modules, par exemple similaires, 22, 24, 26 associés respectivement à chacun des types de capteurs 12, 14, 16, et qui comprennent avantageusement des moyens de filtrage *f* des signaux représentatifs transmis par les capteurs 12, 14, 16, des moyens d'échantillonnage *, et des moyens 22', 24', 26' de détermination des phaseurs proprement dits sur la base des signaux filtrés échantillonnés. Les modules 22, 24, 26 peuvent être localisés au plus près des capteurs 12, 14, 16, ou être rassemblés au sein du premier module 20 qui est de préférence localisé dans le poste de transformation 8.

Le premier module 20 comprend en outre des moyens 28 pour calculer le couple dérivé de tension MT sur la base du phaseur BT issu du module correspondant 26, et d'une quatrième entrée correspondant aux paramètres du transformateur 8.

Le dispositif 10 selon l'invention comprend un deuxième module 30 de reconstitution du phaseur de tension, et d'appairage des phaseurs de courant et tension MT. Le deuxième module 30 comprend 9 entrées correspondant aux couples amplitude/angle issus des modules de détermination des courant et tension MT 22, 24 et des moyens pour calculer le couple dérivé 28. Le deuxième module 30 comprend des moyens pour calculer, pour chacun des triplets, la puissance active et apparente, des moyens pour déterminer le rapport entre les deux puissances, des moyens pour comparer le rapport à une valeur prédéterminée supérieure au cosinus phi minimal du réseau, par exemple 0,89 ou de préférence 0,93, et des moyens pour sélectionner les phaseurs lorsque les rapports sont tous supérieurs à la valeur prédéterminée. Avantageusement, le deuxième module 30 comprend un système pour effectuer une première sélection de triplets sur la base d'une comparaison angulaire afin de limiter le nombre de calculs.

Le deuxième module 30 comprend de préférence des moyens 32, par exemple une alarme, pour indiquer si aucune des comparaisons issues des moyens correspondants ne donne de résultat positif. Le deuxième module comprend également des moyens pour réaffecter un indice de phase sur la base de l'appairage précédent à chacun des phaseurs issus du premier module 20, et peut comprendre des moyens 34 pour indiquer, pour chaque phase, la paire intensités/tensions correspondant.

Avantageusement, le deuxième module 30 est adapté pour le traitement des données issues de la basse tension ; notamment il comprend les trois entrées correspondantes et des moyens 36 pour réaffecter le même indice de phase A,B,C aux couples amplitude/angle des tensions mesurées au niveau de la basse tension.

Le deuxième module 30 peut être solidaire du premier module 20 ou être déporté dans une centrale de mesure et surveillance.

Le dispositif 10 selon l'invention peut être complété par un troisième module 40 de surveillance du réseau moyenne tension 5. En particulier, le troisième module 40 peut comprendre des moyens 42, 44 pour déterminer des paramètres relatifs aux valeurs moyennes, minimum et maximum sur une fenêtre temporelle, taux harmonique de distortion,... des phaseurs de courant et tension associés à chaque phase, tels qu'issus du deuxième module 30. Le troisième module 40 peut également comprendre des moyens similaires 46 pour la surveillance de la tension basse tension.

Le dispositif 10 selon l'invention peut être complété par un quatrième module 50 permettant de calculer et de surveiller les puissances du réseau moyenne tension 5. Sur la base des phaseurs réindexés de tension reconstituée et de courant, le quatrième module 50 peut être doté de moyens pour calculer la puissance active P, réactive Q et/ou apparente S, le facteur de puissance FP, ce au niveau global 3~ ou pour chaque conducteur, ainsi que le transit d'énergie.

Les différentes informations issues des troisième et quatrième modules 40, 50 sont communiquées à une interface 60, qui peut comprendre des moyens d'affichage 62 et/ou des moyens de transmission 64 vers une unité centrale. L'interface 60 peut également comprendre des moyens 66 pour vérifier que les informations P, Q, ... correspondent à des normes et, si besoin, pour alarmer d'une défaillance.

Le dispositif 10 selon l'invention, dont certains modules 40, 50, 60 peuvent être intégrés à une unité de surveillance de réseau locale de type RTU frontale (« *Remote Terminal Unit »)* ou centrale de type SCADA (« *Supervisory Control And Data Acquisition* »), permet une surveillance du réseau 5 avec une précision (hors performance capteurs) de l'ordre de 1 à 5 % sur les puissances et de 0,5 à 1 % sur les courants et tensions malgré une chaîne de mesure imprécise, et à un coût moindre que les centrales de « *power monitoring* » dédiées. Qui plus est, la mise en place du dispositif 10 selon l'invention ne présente pas de contraintes d'encombrement puisque il peut bénéficier des équipements de télé-conduite existants.

Si les performances demandées pour la surveillance du réseau 5 sont inférieures, il est possible d'alléger le procédé et le dispositif 10 selon l'invention, ainsi que l'équipement du réseau 5, en diminuant le nombre de capteurs 12, 14, 16 et en dérivant les grandeurs manquantes des informations mesurées par rotation angulaire. En particulier, il est possible de ne considérer qu'une mesure de courant et de tension, et de dériver le signal représentatif des deux autres phases par rotation angulaire de 120° en mode normal de fonctionnement de réseau. Le premier module 20 comprend alors des moyens pour déterminer les paramètres correspondants, en amont ou en aval de la détermination des phaseurs. Cette option minimise l'encombrement dû au nombre de capteurs, ainsi que les coûts matériel (capteurs, mais aussi électronique de traitement, mémoire, etc.) et d'installation,

Entre ces deux extrêmes (présence de 9 capteurs ou présence de seulement 3 capteurs), il est possible de ne mesurer un triplet courant ou tension MT que sur une phase, et de déduire les autres par rotation angulaire, alors que les mesures de l'autre grandeur sont toutes réalisées (solution 3V & 1I ou 3I & 1V). Ceci permet de détecter un fonctionnement « anormal » du réseau 5, de type défaut, court-circuit, déséquilibre des tensions, déséquilibres des courants,... afin d'inhiber les fonctions de monitoring de puissance et/ou alarmer la présence d'un dysfonctionnement. En particulier, la solution 3V&1I permet d'envisager une mise en oeuvre dans des applications telles que la permutation de phase, la gestion du plan de tension, alors que la solution 3I&1V permet d'envisager une mise en oeuvre dans des applications telles que la détection/localisation de défaut ou la gestion du déséquilibre des phases.

**Revendications**

1. Procédé de détermination de l'intensité et de la tension de chaque phase d'un réseau (5) triphasé moyenne tension couplé à un transformateur (8) moyenne/basse tension vers un réseau (7) triphasé basse tension, comprenant :

   - l'obtention d'un signal représentatif du courant ($I_{MT\_R}$, $I_{MT\_S}$, $I_{MT\_T}$) circulant sur au moins une phase du réseau moyenne tension (5) et la détermination du couple amplitude/angle du courant ($A_{I\_MT\_R} \angle \theta_{I\_MT\_R}$, $A_{I\_MT\_S} \angle \theta_{I\_MT\_S}$, $A_{I\_MT\_T} \angle \theta_{I\_MT\_T}$) sur chacun des conducteurs de phase sur la base desdits signaux ;
   - l'obtention d'un signal représentatif de la tension ($V_{MT\_U}$, $V_{MT\_V}$, $V_{MT\_W}$) sur au moins une phase du réseau moyenne tension (5) et la détermination de l'angle de la tension ($\theta_{V\_MT\_U}$, $\theta_{V\_MT\_V}$, $\theta_{V\_MT\_W}$) sur chacun des conducteurs de phase sur la base desdits signaux ;
   - l'obtention d'un signal représentatif de la tension ($V_{BT\_X}$, $V_{BT\_Y}$, $V_{BT\_Z}$) sur au moins une phase du réseau basse tension (7) et la détermination du couple amplitude/angle de la tension ($A_{V\_BT\_X} \angle \theta_{V\_BT\_X}$, $A_{V\_BT\_Y} \angle \theta_{V\_BT\_Y}$, $A_{V\_BT\_Z} \angle \theta_{V\_BT\_Z}$) sur chacun des conducteurs de phase sur la base desdits signaux ;
   - le calcul des trois couples dérivés amplitude/angle de la tension ($A_{V\_MT\_X} \angle \theta_{V\_MT\_X}$, $A_{V\_MT\_Y} \angle \theta_{V\_MT\_Y}$, $A_{V\_MT\_Z} \angle \theta_{V\_MT\_Z}$) pour les conducteurs de phase du réseau moyenne tension en modifiant les trois couples amplitude/angle ($A_{V\_BT\_X} \angle \theta_{V\_BT\_X}$, $A_{V\_BT\_Y} \angle \theta_{V\_BT\_Y}$, $A_{V\_BT\_Z} \angle \theta_{V\_BT\_Z}$) déterminés sur le réseau basse tension selon les paramètres caractéristiques du transformateur (8) ;
   - la reconstitution de couples amplitude/angle ($A_{V\_MT\_X} \angle \theta_{V\_MT\_U}$, $A_{V\_MT\_Y} \angle \theta_{V\_MT\_V}$, $A_{V\_MT\_Z} \angle \theta_{V\_MT\_W}$) de tension du réseau moyenne tension en substituant aux couples dérivés ($A_{V\_MT\_X} \angle \theta_{V\_MT\_X}$, $A_{V\_MT\_Y} \angle \theta_{V\_MT\_Y}$, $A_{V\_MT\_Z} \angle \theta_{V\_MT\_Z}$) l'angle par un des angles de tension moyenne tension respectifs déterminés ($\theta_{V\_MT\_U}$, $\theta_{V\_MT\_V}$, $\theta_{V\_MT\_W}$) et
   - l'appariage entre ces couples reconstitués et les couples amplitude/angle d'intensité ($A_{I\_MT\_R} \angle \theta_{I\_MT\_R}$, $A_{I\_MT\_S} \angle \theta_{I\_MT\_S}$, $A_{I\_MT\_T} \angle \theta_{I\_MT\_T}$) pour les conducteurs du réseau moyenne tension, en sélectionnant une paire dont les trois cosinus phi de chaque couple sont supérieurs à 0,89.

2. Procédé selon la revendication 1 dans lequel l'obtention d'un signal représentatif de la tension ($V_{MT\_U}$, $V_{MT\_V}$, $V_{MT\_W}$) sur au moins une phase du réseau moyenne tension (5) comprend l'obtention de trois signaux représentatifs pour chacun des conducteurs de phase.

3. Procédé selon l'une des revendications 1 ou 2 dans lequel l'obtention d'un signal représentatif du courant ($I_{MT\_R}$, $I_{MT\_S}$, $I_{MT\_T}$) circulant sur au moins une phase du réseau moyenne tension (5) comprend l'obtention de trois signaux représentatifs pour chacun des conducteurs de phase.

4. Procédé selon l'une des revendications 1 à 3 dans lequel l'obtention d'un signal représentatif de la tension ($V_{BT\_X}$, $V_{BT\_Y}$, $V_{BT\_Z}$) sur au moins une phase du réseau basse tension (7) comprend l'obtention de trois signaux représentatifs pour chacun des conducteurs de phase.

5. Procédé selon l'une des revendications 1 à 4 dans lequel la reconstitution de couples amplitude/angle de tension ($A_{V\_MT\_X} \angle \theta_{V\_MT\_U}$, $A_{V\_MT\_Y} \angle \theta_{V\_MT\_V}$, $A_{V\_MT\_Z} \angle \theta_{V\_MT\_W}$) et l'appairage entre ces couples reconstitués et les couples amplitude/angle d'intensité ($A_{I\_MT\_R} \angle \theta_{I\_MT\_R}$, $A_{I\_MT\_S} \angle \theta_{I\_MT\_S}$, $A_{I\_MT\_T} \angle \theta_{I\_MT\_T}$) comprend le calcul des puissances active et apparente pour lesdites paires de façon itérative jusqu'à ce qu'une paire présente un cos phi supérieur à 0,89.

6. Procédé selon l'une des revendications 1 à 5 comprenant en outre la réaffectation d'un indice correspondant aux phases du réseau à la paire sélectionnée (($A_{V\_MT\_A} \angle \theta_{V\_MT\_A}$ ; $A_{I\_MT\_A} \angle \theta_{I\_MT\_A}$), ($A_{V\_MT\_B} \angle \theta_{V\_MT\_B}$ ; $A_{I\_MT\_B} \angle \theta_{I\_MT\_B}$), ($A_{V\_MT\_C} \angle \theta_{V\_MT\_C}$ ; $A_{I\_MT\_C} \angle \theta_{I\_MT\_C}$)) de couples amplitude/angle de tension et courant du réseau moyenne tension.

**7.** Procédé de détermination de la puissance de chaque phase du réseau moyenne tension utilisant la détermination des paires intensité/tension pour chaque phase selon la revendication 6 et la multiplication des composants intensité/tension desdites paires réaffectées pour déterminer au moins un des paramètres parmi : les puissances active, réactive et apparente, le facteur de puissance, totaux et par phase, ainsi que les transits d'énergie.

**8.** Procédé de surveillance des paramètres d'un réseau moyenne tension utilisant la détermination des paires intensité/tension pour chaque phase selon la revendication 6 et comprenant la détermination à partir de ces paires d'au moins une parmi : les valeurs efficaces du courant et de la tension dans chaque conducteur ; les taux harmoniques de distorsion respectifs ; les valeurs moyenne, minimum et maximum du courant et de la tension dans chaque conducteur.

**9.** Dispositif (10) de détermination de l'intensité et de la tension de chaque phase d'un réseau triphasé moyenne tension (5) dont le cosinus phi est supérieur à 0,89 couplé à un transformateur moyenne/basse tension (8) vers un réseau triphasé basse tension (7), comportant :

- un premier module (20) d'obtention comprenant :

o des moyens pour recevoir des signaux représentatifs de la tension ($V_{BZ\_X}$, $V_{BT\_Y}$, $V_{BT\_Z}$) du réseau basse tension (7), du courant ($I_{MT\_R}$, $I_{MT\_S}$, $I_{MT\_T}$) et de la tension ($V_{MT\_U}$, $V_{MT\_V}$, $V_{MT\_W}$) du réseau moyenne tension (5) ;

o des moyens (22', 24', 26') pour déterminer, à partir des signaux obtenus, l'angle de la tension ($\theta_{V\_MT\_U}$, $\theta_{V\_MT\_V}$, $\theta_{V\_MT\_W}$) de chaque phase du réseau moyenne tension, l'amplitude et l'angle de l'intensité ($A_{I\_MT\_R} \angle \theta_{I\_MT\_R}$, $A_{I\_MT\_S} \angle \theta_{I\_MT\_S}$, $A_{I\_MT\_T} \angle \theta_{I\_MT\_T}$) de chaque phase du réseau moyenne tension, l'amplitude et l'angle de la tension ($A_{V\_BT\_X} \angle \theta_{V\_BT\_X}$, $A_{V\_BT\_Y} \angle \theta_{V\_BT\_Y}$, $A_{V\_BT\_Z} \angle \theta_{V\_BT\_Z}$) de chaque phase du réseau basse tension ;

o des moyens (28) pour dériver à partir de l'amplitude et l'angle de la tension de chaque phase du réseau basse tension ($A_{V\_BT\_X} \angle \theta_{V\_BT\_X}$, $A_{V\_BT\_Y} \angle \theta_{V\_BT\_Y}$, $A_{V\_BT\_Z} \angle \theta_{V\_BT\_Z}$) déterminés par les moyens adaptés (26) et des paramètres du transformateur (8) des couples dérivés ($A_{V\_MT\_X} \angle \theta_{V\_MT\_X}$, $A_{V\_MT\_Y} \angle \theta_{V\_MT\_Y}$, $A_{V\_MT\_Z} \angle \theta_{V\_MT\_Z}$) amplitude/angle de la tension de chaque phase du réseau moyenne tension ;

- un deuxième module (30) d'appariage comprenant :

o des moyens pour reconstituer des couples amplitude/angle de la tension ($A_{V\_MT\_X} \angle \theta_{V\_MT\_U}$, $A_{V\_MT\_Y} \angle \theta_{V\_MT\_V}$, $A_{V\_MT\_Z} \angle \theta_{V\_MT\_W}$) de chaque phase du réseau moyenne tension en substituant, dans chacun desdits couples dérivés amplitude/angle ($A_{V\_MT\_X} \angle \theta_{V\_MT\_X}$, $A_{V\_MT\_Y} \angle \theta_{V\_MT\_Y}$, $A_{V\_MT\_Z} \angle \theta_{V\_MT\_Z}$), l'angle par un des angles de la tension ($\theta_{V\_MT\_U}$, $\theta_{V\_MT\_V}$, $\theta_{V\_MT\_W}$) de chaque phase du réseau moyenne tension déterminé sur la base des calculs ;

o des moyens pour calculer les puissances active (P) et apparentes (S) des trois composants d'une paire composée d'un couple amplitude/angle de tension reconstitué ($A_{V\_MT\_X} \angle \theta_{V\_MT\_U}$, $A_{V\_MT\_Y} \angle \theta_{V\_MT\_V}$, $A_{V\_MT\_Z} \angle \theta_{V\_MT\_W}$) et d'un couple amplitude/angle d'intensité déterminé ($A_{I\_MT\_R} \angle \theta_{I\_MT\_R}$, $A_{I\_MT\_S} \angle \theta_{I\_MT\_S}$, $A_{I\_MT\_T} \angle \theta_{I\_MT\_T}$) ;

o des moyens pour comparer le rapport entre puissances active et apparente (P/S) pour chaque composant à un cosinus phi minimal du réseau moyenne tension (5) ;

o des moyens pour sélectionner, parmi lesdites paires de couples, la paire dont les trois rapports sont supérieurs à un cos phi minimal et pour attribuer un indice correspondant aux conducteurs de phase identifiés du réseau moyenne tension (5) aux composants de ladite paire (($A_{V-MT\_A} \angle \theta_{V-MT\_A}$; $A_{I\_MT\_A} \angle \theta_{I\_MT\_A}$), ($A_{V\_MT\_B} \angle \theta_{V\_MT\_B}$; $A_{I\_MT\_B} \angle \theta_{I\_MT\_B}$), ($A_{V\_MT\_C} \angle \theta_{V\_MT\_C}$; $A_{I\_MT\_C} \angle \theta_{I\_MT\_C}$)).

**10.** Dispositif selon la revendication 9 dans lequel le deuxième module (30) comprend en outre des moyens (32) pour indiquer si aucune paire ne peut être sélectionnée en raison de la non-conformité de la comparaison au cosinus phi de chaque paire.

**11.** Dispositif selon l'une des revendications 9 à 10 comprenant en outre un troisième module (50) pour déterminer au moins un paramètre de puissance (P) pour chacun des conducteurs de phase du réseau moyenne tension (5) à partir de la paire sélectionnée (($A_{V\_MT\_A} \angle \theta_{V\_MT\_A}$; $A_{I\_MT\_A} \angle \theta_{I\_MT\_A}$), ($A_{V\_MT\_B} \angle \theta_{V\_MT\_B}$; $A_{I\_MT\_B} \angle \theta_{I\_MT\_B}$), ($A_{V\_MT\_C} \angle \theta_{V\_MT\_C}$; $A_{I\_MT\_C} \angle \theta_{I\_MT\_C}$)).

**12.** Dispositif selon l'une des revendications 9 à 11 comprenant en outre un quatrième module (40) pour déterminer des paramètres de surveillance du courant du réseau moyenne tension (5) pour chacun des conducteurs de phase à partir de la paire sélectionnée ($(A_{V\_MT\_A}\angle\theta_{V\_MT\_A}$ ; $A_{I\_MT\_A}\angle\theta_{I\_MT\_A})$, $(A_{V\_MT\_B}\angle\theta_{V\_MT\_B}$ ; $A_{I\_MT\_B}\angle\theta_{I\_MT\_B})$, $(A_{V\_MT\_C}\angle\theta_{V\_MT\_C}$ ; $A_{I\_MT\_C}\angle\theta_{I\_MT\_C}))$.

13. Dispositif selon l'une des revendications 11 ou 12 comprenant en outre une interface (60) pour transmettre les informations issues du troisième ou du quatrième module (40, 50) à un utilisateur.

14. Dispositif selon l'une des revendication 9 à 13 comprenant un outre des moyens de mesure (16) des signaux représentatifs de la tension ($V_{BT\_X}$, $V_{BT\_Y}$, $V_{BT\_Z}$) du réseau basse tension (7), des moyens de mesure (12) des signaux représentatifs du courant ($I_{MT\_R}$, $I_{MT\_S}$, $I_{MT\_T}$) moyenne tension et des moyens de mesure (14) des signaux représentatifs de la tension ($V_{MT\_U}$, $V_{MT\_V}$, $V_{MT\_W}$) du réseau moyenne tension (5).

**Patentansprüche**

1. Verfahren zur Bestimmung der Stärke und der Spannung jeder Phase eines dreiphasigen Mittelspannungsnetzes (5), das mit einem Mittel- /Niedrigspannungswandler (8) zu einem dreiphasigen Niederspannungsnetz (7) verbunden ist, umfassend:

   - das Erhalten eines repräsentativen Signals des Stroms ($I_{MT\_R}$, $I_{MT\_S}$, $I_{MT\_T}$), der auf mindestens einer Phase des Mittelspannungsnetzes (5) fließt, und das Bestimmen des Paares Amplitude/Winkel des Stroms ($A_{I\_MT\_R}\angle\theta_{I\_MT\_R}$, $A_{I\_MT\_S}\angle\theta_{I\_MT\_S}$, $A_{I\_MT\_T}\angle\theta_{I\_MT\_T}$) auf jedem der Phasenleiter auf der Grundlage der Signale;
   - das Erhalten eines repräsentativen Signals der Spannung ($V_{MT\_U}$, $V_{MT\_V}$, $V_{MT\_W}$) auf mindestens einer Phase des Mittelspannungsnetzes (5) und das Bestimmen des Winkels der Spannung ($\theta_{V\_MT\_U}$, $\theta_{V\_MT\_V}$, $\theta_{V\_MT\_W}$) auf jedem der Phasenleiter auf der Grundlage der Signale;
   - das Erhalten eines repräsentativen Signals der Spannung ($V_{BT\_X}$, $V_{BT\_Y}$, $V_{BT\_Z}$) auf mindestens einer Phase des Niederspannungsnetzes (7) und das Bestimmen des Paares Amplitude/Winkel der Spannung ($A_{V\_BT\_X}\angle\theta_{V\_BT\_X}$, $A_{V\_BT\_Y}\angle\theta_{V\_BT\_Y}$, $A_{V\_BT\_Z}\angle\theta_{V\_BT\_Z}$) auf jedem der Phasenleiter auf der Grundlage der Signale;
   - das Berechnen der drei abgeleiteten Paare Amplitude/Winkel der Spannung ($A_{V\_MT\_X}\angle\theta_{V\_MT\_X}$, $A_{V\_MT\_Y}\angle\theta_{V\_MT\_Y}$, $A_{V\_MT\_Z}\angle\theta_{V\_MT\_Z}$) für die Phasenleiter des Mittelspannungsnetzes, indem die drei Paare Amplitude/Winkel ($A_{V\_BT\_X}\angle\theta_{V\_BT\_X}$, $A_{V\_BT\_Y}\angle\theta_{V\_BT\_Y}$, $A_{V\_BT\_Z}\angle\theta_{V\_BT\_Z}$) modifiziert werden, die auf dem Niederspannungsnetz nach den charakteristischen Parametern des Wandlers (8) bestimmt werden;
   - das Rekonstruieren der Paare Amplitude/Winkel ($A_{V\_MT\_X}\angle\theta_{V\_MT\_U}$, $A_{V\_MT\_Y}\angle\theta_{V\_MT\_V}$, $A_{V\_MT\_Z}\angle\theta_{V\_MT\_W}$) der Spannung des Mittelspannungsnetzes, indem bei den abgeleiteten Paaren ($A_{V\_MT\_X}\angle\theta_{V\_MT\_X}$, $A_{V\_MT\_Y}\angle\theta_{V\_MT\_Y}$, $A_{V\_MT\_Z}\angle\theta_{V\_MT\_Z}$) der Winkel durch einen der jeweiligen bestimmten Spannungswinkel der Mittelspannung ($\theta_{V\_MT\_U}$, $\theta_{V\_MT\_V}$, $\theta_{V\_MT\_W}$) ersetzt wird, und
   - das Paaren zwischen den rekonstruierten Paaren und den Paaren Amplitude/Winkel der Stärke ($A_{I\_MT\_R}\angle\theta_{I\_MT\_R}$, $A_{I\_MT\_S}\angle\theta_{I\_MT\_S}$, $A_{I\_MT\_T}\angle\theta_{I\_MT\_T}$) für die Leiter des Mittelspannungsnetzes, indem ein Paar gewählt wird, dessen Kosinus phi von jedem Paar größer als 0,89 ist.

2. Verfahren nach Anspruch 1, wobei das Erhalten eines repräsentativen Signals der Spannung ($V_{MT\_U}$, $V_{MT\_V}$, $V_{MT\_W}$) auf mindestens einer Phase des Mittelspannungsnetzes (5) das Erhalten von drei repräsentativen Signalen für jeden der Phasenleiter aufweist.

3. Verfahren nach Anspruch 1 oder 2, wobei das Erhalten eines repräsentativen Signals des Stroms ($I_{MT\_R}$, $I_{MT\_S}$, $I_{MT\_T}$), der auf mindestens einer Phase des Mittelspannungsnetzes (5) fließt, das Erhalten von drei repräsentativen Signalen für jeden der Phasenleiter aufweist.

4. Verfahren nach einem der Ansprüche 1 bis 3, wobei das Erhalten eines repräsentativen Signals der Spannung ($V_{BT\_X}$, $V_{BT\_Y}$, $V_{BT\_Z}$) auf mindestens einer Phase des Niederspannungsnetzes (7) das Erhalten von drei repräsentativen Signalen für jeden der Phasenleiter aufweist.

5. Verfahren nach einem der Ansprüche 1 bis 4, wobei das Rekonstruieren der Paare Amplitude/Winkel der Spannung ($A_{V\_MT\_X}\angle\theta_{V\_MT\_U}$, $A_{V\_MT\_Y}\angle\theta_{V\_MT\_V}$, $A_{V\_MT\_Z}\angle\theta_{V\_MT\_W}$) und das Paaren zwischen den rekonstruierten Paaren und den Paaren Amplitude/Winkel der Stärke ($A_{I\_MT\_R}\angle\theta_{I\_MT\_R}$, $A_{I\_MT\_S}\angle\theta_{I\_MT\_S}$, $A_{I\_MT\_T}\angle\theta_{I\_MT\_T}$) das Berechnen der Wirk- und Scheinleistung für die Paare auf iterative Weise aufweist, bis ein Paar einen Kosinus phi aufweist, der größer als 0,89 ist.

6. Verfahren nach einem der Ansprüche 1 bis 5, ferner umfassend das Neuzuweisen eines Indexes, der den Phasen des Spannungsnetzes entspricht, zu dem gewählten Paar ($(A_{V\_MT\_A}\angle\theta_{V\_MT\_A}$ ; $A_{I\_MT\_A}\angle\theta_{I\_MT\_A})$, $(A_{V\_MT\_B}\angle\theta_{V\_MT\_B}$ ;

$A_{I\_MT\_B} \angle \theta_{I\_MT\_B}$), ($A_{V\_MT\_C} \angle \theta_{V\_MT\_C}$ ; $A_{I\_MT\_C} \angle \theta_{I\_MT\_C}$)) von Paaren Amplitude/Winkel der Spannung und des Stroms des Mittelspannungsnetzes.

**7.** Verfahren zur Bestimmung der Leistung jeder Phase des Mittelspannungsnetzes, das die Bestimmung der Paare Stärke/Spannung für jede Phase nach Anspruch 6 und die Multiplikation der Komponenten Stärke/Spannung der neu zugewiesenen Paare verwendet, um mindestens einen Parameter aus: der Wirk-, Blind- und Scheinleistung, dem Gesamtleistungsfaktor und dem Leistungsfaktor pro Phase und den Energiedurchleitungen zu bestimmen.

**8.** Verfahren zum Überwachen der Parameter eines Mittelspannungsnetzes, das die Bestimmung der Paare Stärke/Spannung für jede Phase nach Anspruch 6 verwendet und die Bestimmung, ausgehend von diesen Paaren von mindestens einem unter: den Effektivwerten des Stroms und der Spannung in jedem Leiter; den jeweiligen Oberschwingungsgehalten; dem Mittel-, Minimal- und Maximalwert des Stroms und der Spannung in jedem Leiter aufweist.

**9.** Vorrichtung (10) zur Bestimmung der Stärke und der Spannung jeder Phase eines dreiphasigen Mittelspannungsnetzes (5), dessen Kosinus phi größer als 0,89 ist, das mit einem Mittel- /Niedrigspannungswandler (8) zu einem dreiphasigen Niederspannungsnetz (7) verbunden ist, umfassend:

- ein erstes Modul (20) zum Erhalten, umfassend:

∘ Mittel, um repräsentative Signale der Spannung ($V_{BT\_X}$, $V_{BT\_Y}$, $V_{BT\_Z}$) des Niederspannungsnetzes (7), des Stroms ($I_{MT\_R}$, $I_{MT\_S}$, $I_{MT\_T}$) und der Spannung ($V_{MT\_U}$, $V_{MT\_V}$, $V_{MT\_W}$) des Mittelspannungsnetzes (5) zu empfangen;
∘ Mittel (22', 24', 26'), um, ausgehend von den erhaltenen Signalen den Winkel der Spannung ($\theta_{V\_MT\_U}$, $\theta_{V\_MT\_V}$, $\theta_{V\_MT\_W}$) jeder Phase des Mittelspannungsnetzes, die Amplitude und den Winkel der Stärke ($A_{I\_MT\_R} \angle \theta_{I\_MT\_R}$, $A_{I\_MT\_S} \angle \theta_{I\_MT\_S}$, $A_{I\_MT\_T} \angle \theta_{I\_MT\_T}$) jeder Phase des Mittelspannungsnetzes, die Amplitude und den Winkel der Spannung ($A_{V\_BT\_X} \angle \theta_{V\_BT\_X}$, $A_{V\_BT\_Y} \angle \theta_{V\_BT\_Y}$, $A_{V\_BT\_Z} \angle \theta_{V\_BT\_Z}$) jeder Phase des Niederspannungsnetzes zu bestimmen;
∘ Mittel (28), um, ausgehend von der Amplitude und dem Winkel der Spannung jeder Phase des Niederspannungsnetzes ($A_{V\_BT\_X} \angle \theta_{V\_BT\_X}$, $A_{V\_BT\_Y} \angle \theta_{V\_BT\_Y}$,

$A_{V\_BT\_Z} \angle \theta_{V\_BT\_Z}$), die durch die geeigneten Mittel (26) und charakteristische Parameter des Wandlers (8) bestimmt sind, abgeleitete Paare ($A_{V\_MT\_X} \angle \theta_{V\_MT\_X}$, $A_{V\_MT\_Y} \angle \theta_{V\_MT\_Y}$, $A_{V\_MT\_Z} \angle \theta_{V\_MT\_Z}$) Amplitude/Winkel der Spannung jeder Phase des Mittelspannungsnetzes abzuleiten;

- ein zweites Modul (30) zum Paaren, umfassend:

∘ Mittel, um Paare Amplitude/Winkel der Spannung ($A_{V\_MT\_X} \angle \theta_{V\_MT\_U}$, $A_{V\_MT\_Y} \angle \theta_{V\_MT\_V}$, $A_{V\_MT\_Z} \angle \theta_{V\_MT\_W}$) jeder Phase des Mittelspannungsnetzes zu rekonstruieren, indem in jedem der abgeleiteten Paare Amplitude/Winkel ($A_{V\_MT\_X} \angle \theta_{V\_MT\_X}$, $A_{V\_MT\_Y} \angle \theta_{V\_MT\_Y}$, $A_{V\_MT\_Z} \angle \theta_{V\_MT\_Z}$) der Winkel durch einen der Winkel der Spannung ($\theta_{V\_MT\_U}$, $\theta_{V\_MT\_V}$, $\theta_{V\_MT\_W}$) jeder Phase des Mittelspannungsnetzes, der auf der Grundlage der Berechnungen bestimmt ist, ersetzt wird;
∘ Mittel, um die Wirkleistung (P) und die Scheinleistung (S) der drei Komponenten eines Paares zu berechnen, das aus einem rekonstruierten Paar Amplitude/Winkel der Spannung ($A_{V\_MT\_X} \angle \theta_{V\_MT\_U}$, $A_{V\_MT\_Y} \angle \theta_{V\_MT\_V}$, $A_{V\_MT\_Z} \angle \theta_{V\_MT\_W}$) Und einem bestimmten Paar Amplitude/Winkel der Stärke ($A_{I\_MT\_R} \angle \theta_{I\_MT\_R}$, $A_{I\_MT\_S} \angle \theta_{I\_MT\_S}$, $A_{I\_MT\_T} \angle \theta_{I\_MT\_T}$) zusammengesetzt ist;
∘ Mittel, um das Verhältnis zwischen der Wirk- und der Scheinleistung (P/S) für jede Komponente mit einem minimalen Kosinus phi des Mittelspannungsnetzes (5) zu vergleichen;
∘ Mittel, um aus den Paaren von Paaren das Paar auszuwählen, von dem die drei Verhältnisse größer als ein minimaler Kosinus phi sind, und um den Komponenten des Paares (($A_{V\_MT\_A} \angle \theta_{V\_MT\_A}$ ; $A_{I\_MT\_A} \angle \theta_{I\_MT\_A}$), ($A_{V\_MT\_B} \angle \theta_{V\_MT\_B}$ ; $A_{I\_MT\_B} \angle \theta_{I\_MT\_B}$), ($A_{V\_MT\_C} \angle \theta_{V\_MT\_C}$ ; $A_{I\_MT\_C} \angle \theta_{I\_MT\_C}$)) einen Index zuzuordnen, der den identifizierten Phasenleitern des Mittelspannungsnetzes (5) entspricht.

**10.** Vorrichtung nach Anspruch 9, wobei das zweite Modul (30) ferner Mittel (32) aufweist, um anzugeben, ob auf Grund der Nichtkonformität des Vergleichs mit dem Kosinus phi von jedem Paar kein Paar ausgewählt werden kann.

**11.** Vorrichtung nach einem der Ansprüche 9 bis 10, ferner umfassend ein drittes Modul (50), um mindestens einen Leistungsparameter (P) für jeden der Phasenleiter des Mittelspannungsnetzes (5), ausgehend von dem ausgewählten Paar ((A$_{V\_MT\_A}\angle\theta_{V\_MT\_A}$ ; A$_{I\_MT\_A}\angle\theta_{I\_MT\_A}$), (A$_{V\_MT\_B}\angle\theta_{V\_MT\_B}$ ; A$_{I\_MT\_B}\angle\theta_{I\_MT\_B}$), (A$_{V\_MT\_C}\angle\theta_{V\_MT\_C}$ ; A$_{I\_MT\_C}\angle\theta_{I\_MT\_C}$)) zu bestimmen.

**12.** Vorrichtung nach einem der Ansprüche 9 bis 11, ferner umfassend ein viertes Modul (40), um Überwachungsparameter des Stroms des Mittelspannungsnetzes (5) für jeden der Phasenleiter ausgehend von dem ausgewählten Paar ((A$_{V\_MT\_A}\angle\theta_{V\_MT\_A}$ ; A$_{I\_MT\_A}\angle\theta_{I\_MT\_A}$), (A$_{V\_MT\_B}\angle\theta_{V\_MT\_B}$ ; A$_{I\_MT\_B}\angle\theta_{I\_MT\_B}$), (A$_{V\_MT\_C}\angle\theta_{V\_MT\_C}$ ; A$_{I\_MT\_C}\angle\theta_{I\_MT\_C}$)) zu bestimmen.

**13.** Vorrichtung nach einem der Ansprüche 11 oder 12, ferner umfassend eine Schnittstelle (60), um die Informationen, die aus dem dritten oder dem vierten Modul (40, 50) hervorgegangen sind, an einen Benutzer zu übertragen.

**14.** Vorrichtung nach einem der Ansprüche 9 bis 13, ferner umfassend Mittel zum Messen (16) der repräsentativen Signale der Spannung (V$_{BT\_X}$, V$_{BT\_Y}$, V$_{BT\_Z}$) des Niederspannungsnetzes (7), Mittel zum Messen (12) der repräsentativen Signale des Mittelspannungsstroms (I$_{MT\_R}$, I$_{MT\_S}$, I$_{MT\_T}$) und Mittel zum Messen (14) der repräsentativen Signale der Spannung (V$_{MT\_U}$, V$_{MT\_V}$, V$_{MT\_W}$) des Mittelspannungsnetzes (5).

**Claims**

**1.** Method for determining the amperage and the voltage of each phase of a medium voltage three-phase network (5) coupled with a medium/low voltage transformer (8) to a low voltage three-phase network (7), comprising:

- the acquisition of a signal that is representative of the current (I$_{MT\_R}$, I$_{MT\_S}$, I$_{MT\_T}$) flowing on at least one phase of the medium voltage network (5) and the determination of the amplitude/angle couple of the current (A$_{I\_MT\_R}\angle\theta_{I\_MT\_R}$, A$_{I\_MT\_S}\angle\theta_{I\_MT\_S}$, A$_{I\_MT\_T}\angle\theta_{I\_MT\_T}$) on each of the phase conductors on the basis of said signals;
- the acquisition of a signal that is representative of the voltage (V$_{MT\_U}$, V$_{MT\_V}$, V$_{MT\_W}$) on at least one phase of the medium voltage network (5) and the determination of the angle of the voltage ($\theta_{V\_MT\_U}$, $\theta_{V\_MT\_V}$, $\theta_{V\_MT\_W}$) on each of the phase conductors on the basis of said signals;
- the acquisition of a signal that is representative of the voltage (V$_{BT\_X}$, V$_{BT\_Y}$, V$_{BT\_Z}$) on at least one phase of the low voltage network (7) and the determination of the amplitude/angle couple of the voltage (A$_{V\_BT\_X}\angle\theta_{V\_BT\_X}$, A$_{V\_BT\_Y}\angle\theta_{V\_BT\_Y}$, A$_{V\_BT\_Z}\angle\theta_{V\_BT\_Z}$) on each of the phase conductors on the basis of said signals;
- the calculation of the three derived amplitude/angle couples of the voltage (A$_{V\_MT\_X}\angle\theta_{V\_MT\_X}$, A$_{V\_MT\_Y}\angle\theta_{V\_MT\_Y}$, A$_{V\_MT\_Z}\angle\theta_{V\_MT\_Z}$) for the phase conductors of the medium voltage network by modifying the three amplitude/angle couples (A$_{V\_BT\_X}\angle\theta_{V\_BT\_X}$, A$_{V\_BT\_Y}\angle\theta_{V\_BT\_Y}$, A$_{V\_BT\_Z}\angle\theta_{V\_BT\_Z}$) determined on the low voltage network according to the characteristic parameters of the transformer (8);
- the reconstruction of voltage amplitude/angle couples (A$_{V\_MT\_X}\angle\theta_{V\_MT\_U}$, A$_{V\_MT\_Y}\angle\theta_{V\_MT\_V}$, A$_{V\_MT\_Z}\angle\theta_{V\_MT\_W}$) of the medium voltage network by substituting the angle in the derived couples (A$_{V\_MT\_X}\angle\theta_{V\_MT\_X}$, A$_{V\_MT\_Y}\angle\theta_{V\_MT\_Y}$, A$_{V\_MT\_Z}\angle\theta_{V\_MT\_Z}$) with one of the determined respective medium voltage angles ($\theta_{V\_MT\_U}$, $\theta_{V\_MT\_V}$, $\theta_{V\_MT\_W}$) and
- the pairing between these reconstructed couples and the amperage amplitude/angle couples (A$_{I\_MT\_R}\angle\theta_{I\_MT\_R}$, A$_{I\_MT\_S}\angle\theta_{I\_MT\_S}$, A$_{I\_MT\_T}\angle\theta_{I\_MT\_T}$) for the conductors of the medium voltage network, by selecting a pair for which the three cosines of phi for each couple are greater than 0.89.

**2.** Method according to Claim 1, in which the acquisition of a signal that is representative of the voltage (V$_{MT\_U}$, V$_{MT\_V}$, V$_{MT\_W}$) on at least one phase of the medium voltage network (5) comprises the acquisition of three representative signals for each of the phase conductors.

**3.** Method according to either of Claims 1 and 2, in which the acquisition of a signal that is representative of the current (I$_{MT\_R}$, I$_{MT\_S}$, I$_{MT\_T}$) flowing on at least one phase of the medium voltage network (5) comprises the acquisition of three representative signals for each of the phase conductors.

**4.** Method according to one of Claims 1 to 3, in which the acquisition of a signal that is representative of the voltage (V$_{BT\_X}$, V$_{BT\_Y}$, V$_{BT\_Z}$) on at least one phase of the low voltage network (7) comprises the acquisition of three representative signals for each of the phase conductors.

**5.** Method according to one of Claims 1 to 4, in which the reconstruction of voltage amplitude/angle couples (A$_{V\_MT\_X}\angle\theta_{V\_MT\_U}$, A$_{V\_MT\_Y}\angle\theta_{V\_MT\_V}$, A$_{V\_MT\_Z}\angle\theta_{V\_MT\_W}$) and the pairing between these reconstructed couples and the amperage amplitude/angle couples $(A_{I\_MT\_R} \angle \theta_{I\_MT\_R}$, $A_{I\_MT\_S} \angle \theta_{I\_MT\_S}$, $A_{I\_MT\_T} \angle \theta_{I\_MT\_T})$ comprises the calculation of the active and apparent powers for said pairs in an iterative manner until one pair has a cos phi of greater than 0.89.

6. Method according to one of Claims 1 to 5, furthermore comprising the reassignment of an index, corresponding to the phases of the network, to the selected pair $((A_{V\_MT\_A} \angle \theta_{V\_MT\_A}$; $A_{I\_MT\_A} \angle \theta_{I\_MT\_A})$, $(A_{V\_MT\_B} \angle \theta_{V\_MT\_B}$; $A_{I\_MT\_B} \angle \theta_{I\_MT\_B})$, $(A_{V\_MT\_C} \angle \theta_{V\_MT\_C}$; $A_{I\_MT\_C} \angle \theta_{I\_MT\_C}))$ of voltage and current amplitude/angle couples of the medium voltage network.

7. Method for determining the power of each phase of the medium voltage network using the determination of the amperage/voltage pairs for each phase according to Claim 6 and the multiplication of the amperage/voltage components of said reassigned pairs in order to determine at least one of the parameters from among: the active, reactive and apparent powers, the power factor, totals and per phase, as well as the energy transits.

8. Method for monitoring the parameters of a medium voltage network using the determination of the amperage/voltage pairs for each phase according to Claim 6 and comprising the determination, from these pairs, of at least one from among: the RMS values of the current and the voltage in each conductor; the respective harmonic distortion ratios; the mean, minimum and maximum values of the current and of the voltage in each conductor.

9. Device (10) for determining the amperage and the voltage of each phase of a medium voltage three-phase network (5), for which the cosine of phi is greater than 0.89, coupled with a medium/low voltage transformer (8) to a low voltage three-phase network (7), comprising:

   - a first acquisition module (20) comprising:

     o means for receiving signals that are representative of the voltage $(V_{BT\_X}$, $V_{BT\_Y}$, $V_{BT\_Z})$ of the low voltage network (7), of the current $(I_{MT\_R}$, $I_{MT\_S}$, $I_{MT\_T})$ and of the voltage $(V_{MT\_U}$, $V_{MT\_V}$, $V_{MT\_W})$ of the medium voltage network (5);
     o means (22', 24', 26') for determining, from the acquired signals, the angle of the voltage $(\theta_{V\_MT\_U}$, $\theta_{V\_MT\_V}$, $\theta_{V\_MT\_W})$ of each phase of the medium voltage network, the amplitude and the angle of the amperage $(A_{I\_MT\_R} \angle \theta_{I\_MT\_R}$, $A_{I\_MT\_S} \angle \theta_{I\_MT\_S}$, $A_{I\_MT\_T} \angle \theta_{I\_MT\_T})$ of each phase of the medium voltage network, the amplitude and the angle of the voltage $(A_{V\_BT\_X} \angle \theta_{V\_BT\_X}$, $A_{V\_BT\_Y} \angle \theta_{V\_BT\_Y}$, $A_{V\_BT\_Z} \angle \theta_{V\_BT\_Z})$ of each phase of the low voltage network;
   o means (28) for deriving, from the amplitude and the angle of the voltage of each phase of the low voltage network $(A_{V\_BT\_X} \angle \theta_{V\_BT\_X}$, $A_{V\_BT\_Y} \angle \theta_{V\_BT\_Y}$, $A_{V\_BT\_Z} \angle \theta_{V\_BT\_Z})$ that are determined by the appropriate means (26) and parameters of the transformer (8), of the derived amplitude/angle couples $(A_{V\_MT\_X} \angle \theta_{V\_MT\_X}$, $A_{V\_MT\_Y} \angle \theta_{V\_MT\_Y}$, $A_{V\_MT\_} \angle \theta_{V\_MT\_Z})$ of the voltage of each phase of the medium voltage network;

   - a second pairing module (30) comprising:

     ∘ means for reconstructing amplitude/angle couples of the voltage $(A_{V\_MT\_X} \angle \theta_{V\_MT\_U}$, $A_{V\_MT\_Y} \angle \theta_{V\_MT\_V}$, $A_{V\_MT\_Z} \angle \theta_{V-MT\_W})$ of each phase of the medium voltage network by substituting the angle, in each of said derived amplitude/angle couples $(A_{V\_MT\_X} \angle \theta_{V\_MT\_X}$, $A_{V\_MT\_Y} \angle \theta_{V\_MT\_Y}$, $A_{V\_MT\_Z} \angle \theta_{V\_MT\_Z})$, with one of the angles of the voltage $(\theta_{V\_MT\_U}$, $\theta_{V\_MT\_V}$, $\theta_{V\_MT\_W})$ of each phase of the medium voltage network determined on the basis of the calculations;
     ∘ means for calculating the active (P) and apparent (S) powers of the three components of a pair composed of a reconstructed voltage amplitude/angle couple $(A_{V\_MT\_X} \angle \theta_{V\_MT\_U}$, $A_{V\_MT\_Y} \angle \theta_{V\_MT\_V}$, $A_{V\_MT\_Z} \angle \theta_{V\_MT\_W})$ and of a determined amperage amplitude/angle couple $(A_{I\_MT\_R} \angle \theta_{I\_MT\_R}$, $A_{I\_MT\_S} \angle \theta_{I\_MT\_S}$, $A_{I\_MT\_T} \angle \theta_{I\_MT\_T})$;
     ∘ means for comparing the ratio between active and apparent powers (P/S) for each component with a minimum cosine of phi for the medium voltage network (5);
     ∘ means for selecting, from among said pairs of couples, the pair for which the three ratios are greater than a minimum cos phi and for attributing an index, corresponding to the identified phase conductors of the medium voltage network (5), to the components of said pair $((A_{V\_MT\_A} \angle \theta_{V\_MT\_A}$; $A_{I\_MT\_A} \angle \theta_{I\_MT\_A})$, $(A_{V\_MT\_B} \angle \theta_{V\_MT\_B}$; $A_{I\_MT\_B} \angle \theta_{I\_MT\_B})$, $(A_{V\_MT\_C} \angle \theta_{V\_MT\_C}$; $A_{I\_MT\_C} \angle \theta_{I\_MT\_C}))$.

10. Device according to Claim 9, in which the second module (30) furthermore comprises means (32) for indicating whether none of the pairs can be selected due to the non-conformity of the comparison with the cosine of phi for each pair.

**11.** Device according to either of Claims 9 and 10, furthermore comprising a third module (50) for determining, from the selected pair (($A_{V\_MT\_A} \angle \theta_{V\_MT\_A}$; $A_{I\_MT\_A} \angle \theta_{I\_MT\_A}$), ($A_{V\_MT\_B} \angle \theta_{V\_MT\_B}$; $A_{I\_MT\_B} \angle \theta_{I\_MT\_B}$), ($A_{V\_MT\_C} \angle \theta_{V\_MT\_C}$; $A_{I\_MT\_C} \angle \theta_{I\_MT\_C}$)), at least one power parameter (P) for each of the phase conductors of the medium voltage network (5).

**12.** Device according to one of Claims 9 to 11, furthermore comprising a fourth module (40) for determining, from the selected pair (($A_{V\_MT\_A} \angle \theta_{V\_MT\_A}$; $A_{I\_MT\_A} \angle \theta_{I\_MT\_A}$), ($A_{V\_MT\_B} \angle \theta_{V\_MT\_B}$; $A_{I\_MT\_B} \angle \theta_{I\_MT\_B}$), ($A_{V\_MT\_C} \angle \theta_{V\_MT\_C}$; $A_{I\_MT\_C} \angle \theta_{I\_MT\_C}$)), parameters for monitoring the current of the medium voltage network (5) for each of the phase conductors.

**13.** Device according to either of Claims 11 and 12, furthermore comprising an interface (60) for transmitting the information arising from the third or the fourth module (40, 50) to a user.

**14.** Device according to one of Claims 9 to 13, furthermore comprising means for measuring (16) the signals that are representative of the voltage ($V_{BT\_X}$, $V_{BT\_Y}$, $V_{BT\_Z}$) of the low voltage network (7), means for measuring (12) the signals that are representative of the medium voltage current ($I_{MT\_R}$, $I_{MT\_S}$, $I_{MT\_T}$) and means for measuring (14) the signals that are representative of the voltage ($V_{MT\_U}$, $V_{MT-V}$, $V_{MT\_W}$) of the medium voltage network (5).

THT / HTB          HTA / MT          BT

Fig. 1

**Fig. 2A**

EP 2 731 220 B1

**Fig. 2B**

**EP 2 731 220 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2010083164 A
- WO 03079512 A
- WO 0048284 A
- EP 1324455 A